# EUROPÄISCHE PATENTANMELDUNG

(11) **EP 3 839 982 A1**
(43) Veröffentlichungstag der Anmeldung: **23.06.2021**
(21) Anmeldenummer: 20209699.6
(22) Anmeldetag: 25.11.2020
(51) Int. Cl.: H01B 17/00, H01B 17/28, H01B 17/36, G01R 31/12, H01B 17/32

(54) **HOCHSPANNUNGSDURCHFÜHRUNG UND VERFAHREN ZU DEREN BETRIEBSÜBERWACHUNG**

(30) Priorität: 20.12.2019 DE 102019220367
(71) Anmelder: Siemens Aktiengesellschaft, 80333 München (DE)
(72) Erfinder: Langens, Achim, 53797 Lohmar (DE)

(57) **Zusammenfassung**

Die Erfindung betrifft eine Hochspannungsdurchführung (1) mit einem Isolierkörper (2), der ein Isoliergas und einen Isolierfeststoff umfasst, einem durch den Isolierkörper hindurchgeführten Innenleiter (3) sowie mit einem Befestigungsflansch (6), der zum Befestigen der Hochspannungsdurchführung an einer Wandung dient. Die Erfindung zeichnet sich durch einen Sensor (10) aus, der am Befestigungsflansch angeordnet ist und zum Erfassen wenigstens eines Reaktionsproduktes des Isoliergases und/oder des Isolierfeststoffes eingerichtet ist. Die Erfindung betrifft ferner ein Verfahren zum Überwachen eines Betriebszustandes einer erfindungsgemäßen Hochspannungsdurchführung.

## Beschreibung

Die Erfindung betrifft eine Hochspannungsdurchführung mit einem Isolierkörper, der (wenigstens) ein Isoliergas sowie (wenigstens) einen Isolierfeststoff umfasst, einem durch den Isolierkörper hindurchgeführten Innenleiter sowie mit einem Befestigungsflansch, der zum Befestigen der Hochspannungsdurchführung an einer Wandung dient.

Eine Hochspannungsdurchführung ist üblicherweise auf ein Isolieren von Hochspannungen oberhalb von 1 kV, bevorzugt oberhalb von 100 kV ausgelegt. Im Allgemeinen hat eine solche Hochspannungsdurchführung die Aufgabe, den im Betrieb auf einem Hochspannungspotential liegenden Innenleiter der Hochspannungsdurchführung von einer auf Erdpotential befindlichen Umgebung, beispielsweise einer Hallenwand einer Hochspannungsanlage oder einer Kesselwand eines Transformators, elektrisch zu isolieren.

Die Aufgabe der Erfindung ist es, eine eingangs genannte Hochspannungsdurchführung vorzuschlagen, die möglichst zuverlässig im Betrieb ist.

Die Aufgabe wird bei einer artgemäßen Hochspannungsdurchführung erfindungsgemäß durch einen Sensor gelöst, der am Befestigungsflansch angeordnet ist und zum Erfassen wenigstens eines Reaktionsproduktes des wenigstens einen Isoliergases und/oder des wenigstens einen Isolierfeststoffes eingerichtet ist. Durch den Einsatz des Sensors ist es vorteilhaft möglich geworden, Sekundäreffekte in einem elektrischen Fehlerfall in der Hochspannungsdurchführung zu analysieren und zu bewerten. In einem elektrischen Fehlerfall wird das Isoliergas zu Reaktionen angeregt, beispielsweise durch elektrische Teilentladungen, so dass Reaktionsprodukte des Isoliergases entstehen, die auch Abbauprodukte sein können. Zudem kann sich auch der Isolierfeststoff, beispielsweise Harz, Papier oder andere Isolierfeststoffe, wie synthetische Flächenmaterialien, durch Reaktionen derart verändern, dass ebenso Reaktionsprodukte entstehen. Das Erfassen der Reaktionsprodukte ermöglicht es, Rückschlüsse über einen elektrischen Zustand der Hochspannungsdurchführung abzuleiten. Je nach Fehlerart können sich dabei unterschiedliche Reaktionsprodukte bilden, so dass zudem eine Klassifikation des betreffenden Fehlerfalles vorteilhaft sein kann. Der Sensor befindet sich im Betrieb der Hochspannungsdurchführung im Wesentlich auf Erdpotenzial, da er am Befestigungsflansch angeordnet ist. Dies bedeutet vorteilhaft, dass mittels des Sensors erzeugte Messdaten relativ einfach in Form von elektrischen Signalen kabelgebunden weitergeleitet werden können, beispielsweise an eine externe Auswerteeinheit. Der Sensor kann ein Gassensor sein, der beispielsweise in der Umwelttechnik eingesetzt wird.

Gemäß einer Ausführungsform der Erfindung umfasst der Isolierkörper ein harzimprägniertes Aktivteil sowie eine Nebenisolation mit dem Isoliergas. Die Nebenisolation kann außen um das Aktivteil herum angeordnet sein. Die Nebenisolation kann z.B. einen Trockenschaum umfassen, der mit dem Isoliergas gefüllt ist. Das Aktivteil kann als ein Wickelkörper ausgebildet sein, der durch um einen Wickelkern, beispielsweise den Innenleiter, herumgewickelte Isolierlagen aus einem Papier oder einem Kunststoff gebildet ist. Bevorzugt ist der Kunststoff dabei ein synthetischer Kunststoff, besonders bevorzugt ein synthetisches Vlies. Diese Stoffe haben sich insbesondere bezüglich ihrer Isolationseigenschaften als besonders vorteilhaft erwiesen. Vorzugsweise weist der Vliesstoff ein synthetisches Polymer auf. Das synthetische Polymer kann beispielsweise ein Polyester, besonders bevorzugt Polyethylenterephthalat (PET), sein. Synthetische Polymere sind apolar und somit feuchtigkeitsabweisend.

Ein übliches Isoliergas ist das Schwefelhexafluorid SF6. Ein Vorteil der Verwendung von SF6 ist insbesondere, dass dessen Reaktionsverhalten und damit dessen Reaktionsprodukte wohlbekannt sind. Im Übrigen sind auch die Reaktionsprodukte der verwendeten Isolierfeststoffe hinreichend bekannt.

Die mittels des Sensors erfassten Reaktionsprodukte können beispielsweise eines oder mehrere Gase der Gruppe SO2, H2, CH4, CO und CO2 umfassen, wobei die genannte Liste selbstredend nicht abschließend ist.

Gemäß einer Ausführungsform der Erfindung ist die Hochspannungsdurchführung eine Gleichspannungsdurchführung zum Isolieren einer Gleichspannung. Bei Wechselspannungsdurchführungen kann eine Überwachung anhand einer Auswertung eines nahezu sinusförmigen elektrischen Signals (Spannungsverlaufes) an einem Messanschluss der Hochspannungsdurchführung. Gleichspannungsdurchführungen können hingegen mit vielen unterschiedlichen Spannungsformen betrieben werden. Eine Auswertung des elektrischen Spannungsverlaufes ist aus diesem Grund mit einem vertretbarem technischen Aufwand oft nicht möglich. Daher ist die Auswertung der Reaktionsprodukte des Isoliergases und ggf. des Isolierfeststoffes im Fall einer Gleichspannungsdurchführung besonders vorteilhaft.

Die Erfindung betrifft ferner ein Verfahren zum Überwachen eines Betriebszustandes einer Hochspannungsdurchführung mit einem (zumindest) ein Isoliergas und (zumindest) einen Isolierfeststoff umfassenden Isolierkörper, einem durch den Isolierkörper hindurchgeführten Innenleiter und einem Befestigungsflansch.

Die Aufgabe der Erfindung ist es, ein solches Verfahren anzugeben, das einen möglichst zuverlässigen Betrieb der Hochspannungsdurchführung ermöglicht.

Die Aufgabe wird erfindungsgemäß durch ein artgemäßes Verfahren gelöst, bei dem mittels eines am Befestigungsflansch angeordneten Sensors wenigstens ein Reaktionsprodukt des Isoliergases und/oder des Isolierfeststoffes erfasst wird, wobei ein Messsignal erzeugt und ausgewertet wird. Das Isoliergas der Hochspannungsdurchführung, das sich beispielsweise in einem Gasraum befindet, wird auf spezifische Reaktionsprodukte (auch beispielsweise im Sinne von Abbauprodukten) überwacht und je nach Schadstofftyp oder entsprechende Kombination von Reaktionsprodukten in den unterschiedlichen Fehlerfällen eine Bewertung des Reaktionsproduktes und entsprechend des Fehlers vorgenommen. In dem untersuchten Gas können sich zusätzlich auch Abbauprodukte des Isolierfeststoffes befinden, die mittels des Sensors mit-untersucht werden.

Vorzugsweise wird zum Erfassen des Reaktionsproduktes eine Gasprobe aus einem Gasraum des Isolierkörpers, beispielsweise mittels Absaugen, entnommen und dem Sensor zugeführt. Dazu werden entsprechende Zuleitungen vorgesehen. Die Gasprobe kann nach dem Erfassen in den Gasraum zurückgeführt werden. Ein Vorteil eines solchen Vorgehens liegt insbesondere auch darin, dass der Sensor nicht im Gasraum selbst angeordnet sein muss. Manche Isoliergase, wie beispielsweise SF6, weisen eine chemische Aggressivität auf, durch die im Gasraum angeordneter Sensor nach einer langandauernden Betriebszeit beschädigt werden kann.

Das Erfassen bzw. die Messung muss nicht kontinuierlich erfolgen. Die Gasprobe wird bevorzugt in Zeitabständen von mindestens 24h, beispielsweise einmal täglich oder einmal wöchentlich, wiederholt entnommen und zweckmäßigerweise anschließend untersucht. Denkbar ist jedoch ebenfalls, dass ein kleiner Gasstrom kontinuierlich dem Sensor zugeführt wird.

Gemäß einer Ausführungsform umfasst das Auswerten ein Abgleichen mit vorbestimmten Referenzdaten. Insbesondere kann eine Bewertung bzw. Auswertung auf der Basis von Referenzwerten erfolgen, die in einer geeigneten Datenbank hinterlegt werden.

Das Auswerten umfasst geeigneterweise ein Erkennen einer Teilentladung in der Hochspannungsdurchführung. Generell besteht auf diese Weise die Möglichkeit zum Erkennen von Dauerfehlern, wie kleinen Teilentladungen, die zu einer Senkung der Zuverlässigkeit der Hochspannungsdurchführung senken können. Die Teilentladung kann insbesondere auch ein Teildurchschlag sein. Als weitere Kenngröße ist auch der dielektrische Verlustfaktor denkbar. Dieser ergibt sich aus dem Verhältnis zwischen einem ohmschen Strom und einem rein kapazitiven Strom durch das Dielektrikum des Isolierkörpers. Mit Hilfe des Verlustfaktors lässt sich der Zustand eines Isolierstoffes bewerten. Das Auswerten kann mittels des Sensors selbst oder einer geeigneten Auswerteeinheit durchgeführt werden, die mit dem Sensor zum Austausch von Signalen bzw. Daten verbunden ist. Die gewonnenen Erkenntnisse können als Überwachungskriterium bzw. Abschaltkriterium verwendet werden.

Das oben beschriebene Verfahren kann darüber hinaus in Kombination mit einigen oder allen zuvor offenbarten Merkmalen der Hochspannungsdurchführung durchgeführt werden.

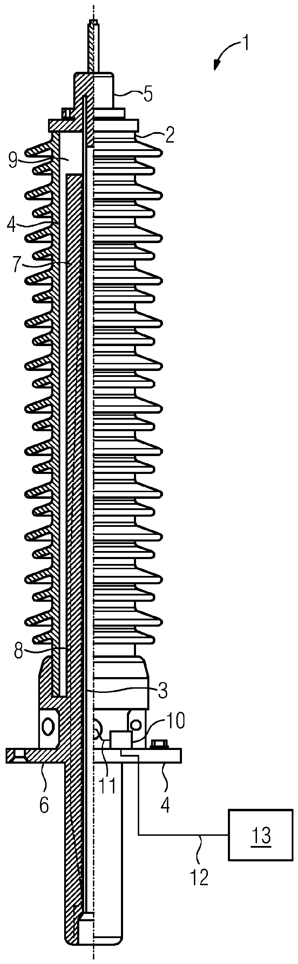

Die Erfindung wird nachfolgend anhand eines in der Figur dargestellten Ausführungsbeispiels weiter erläutert.

Die Figur zeigt ein Ausführungsbeispiel einer erfindungsgemäßen Hochspannungsdurchführung in einer schematischen Darstellung.

In der Figur ist eine Hochspannungsdurchführung 1 dargestellt. Die Hochspannungsdurchführung 1 umfasst einen Isolierkörper 2. Durch den Isolierkörper 2 ist ein rohrförmiger Innenleiter 3 hindurchgeführt.

Der Isolierkörper 2 umfasst ein Gehäuse 4, das in dem in der Figur gezeigten Beispiel aus einem Porzellankörper hergestellt ist. Das Gehäuse 4 erstreckt sich zwischen einer Kopfarmatur 5 und einem Befestigungsflansch 6. Im Betrieb der Hochspannungsdurchführung 1 befindet sich der Innenleiter 3 auf einem elektrischen Potenzial von mehr als 100 kV, während der Befestigungsflansch 6 im Wesentlichen auf Erdpotenzial liegt. Alternativ kann das Gehäuse beispielsweise auch aus einem glasfaserverstärkten Epoxidharzrohr bestehen, auf das Schirme aus Silikonelastomer aufvulkanisiert sind.

Der Isolierkörper 2 umfasst ein Aktivteil 7, das mit einem Epoxidharz imprägnierte Isolierlagen aus Papier oder Kunststoffvlies umfasst. Ferner umfasst das Aktivteil 7 koaxial angeordnete Steuereinlagen aus Aluminiumfolie, die in dem mit einer unterbrochenen Linie 8 gekennzeichneten Bereich des Aktivteils angeordnet sind und eine gleichmäßige Spannungsverteilung am Isolierkörper 2 bewirken. Zwischen dem Gehäuse 4 und dem Aktivteil befindet sich ein Gasraum 9, der zumindest teilweise mit einem Isoliergas und einer Nebenisolation aus Trockenschaum gefüllt ist. Somit umfasst der Isolierkörper 2 mehrere Isolierfeststoffe, nämlich insbesondere das Harz, das Papier bzw. das Vlies und den Trockenschaum.

An dem Befestigungsflansch 4 ist ein Sensor 10 angeordnet, der mittels einer Zuleitung 11 mit dem Gasraum 9 verbunden ist. Mittels der Zuleitung 11 kann eine Gasprobe des Isoliergases dem Sensor zugeführt werden. Der Sensor 10 ist ferner über eine elektrische Kabelverbindung 12 mit einer Auswerteeinheit 13 verbunden. Die Auswerteeinheit 13 ist dazu eingerichtet, ein mittels des Sensors 10 bereitgestelltes Messsignal auszuwerten und entsprechende Fehlerindikatoren zu erzeugen.

Die grundsätzliche Funktionsweise einer Überwachung der Hochspannungsdurchführung 1 kann wie folgt beschrieben werden. In regelmäßigen Abständen (beispielsweise einmal täglich) wird über die Zuleitung 11 dem Sensor 10 eine Gasprobe zugeführt. Der Sensor 10 kann die aufgrund eines Fehlers im Gasraum 9 entstandenen Reaktionsprodukte des Isoliergases bzw. der Isolierfeststoffe erfassen. Der Sensor 10 erzeugt daraufhin ein Messsignal, das eine Information über die in der Gasprobe gefundenen Reaktionsprodukte enthält. Das Messsignal wird anschließend an die Auswerteeinheit 13 weitergeleitet. Die Auswerteeinheit 13 führt eine Auswertung des Messsignals und liefert als Analyseergebnis beispielsweise eine Kategorisierung des Betriebszustandes durch. Alternativ wird die Analyse mittels des Sensors 10 selbst durchgeführt, wobei das Ergebnis an eine übergeordnete Überwachungseinheit geleitet wird. Auf der Grundlage des Ergebnisses werden gegebenenfalls Maßnahmen, wie Wartungsmaßnahmen und/oder eine Abschaltung eingeleitet.

## Patentansprüche

1. Hochspannungsdurchführung (1) mit einem Isolierkörper (2), der ein Isoliergas und einen Isolierfeststoff umfasst, einem durch den Isolierkörper (2) hindurchgeführten Innenleiter (3) sowie mit einem Befestigungsflansch (6),
**gekennzeichnet, durch**
einen Sensor (10), der am Befestigungsflansch (6) angeordnet ist und zum Erfassen wenigstens eines Reaktionsproduktes des Isoliergases und/oder des Isolierfeststoffes eingerichtet ist.

2. Hochspannungsdurchführung (1) nach Anspruch 1,
wobei der Isolierkörper (2) ein harzimprägniertes Aktivteil (7) sowie eine Nebenisolation mit dem Isoliergas umfasst.

3. Hochspannungsdurchführung (1) nach einem der vorangehenden Ansprüche,
wobei das Isoliergas SF6 ist.

4. Hochspannungsdurchführung (1) nach einem der vorangehenden Ansprüche,
wobei das wenigstens eine Reaktionsprodukt eines oder mehrere Gase der Gruppe SO2, H2, CH4, CO und CO2 umfasst.

5. Hochspannungsdurchführung (1) nach einem der vorangehenden Ansprüche,
wobei die Hochspannungsdurchführung (1) eine Gleichspannungsdurchführung zum Isolieren einer Gleichspannung ist.

6. Verfahren zum Überwachen eines Betriebszustandes einer Hochspannungsdurchführung (1) mit einem ein Isoliergas und einen Isolierfeststoff umfassenden Isolierkörper (2), einem durch den Isolierkörper (2) hindurchgeführten Innenleiter (3) und einem Befestigungsflansch (6), bei dem
mittels eines am Befestigungsflansch (6) angeordneten Sensors (10) wenigstens ein Reaktionsprodukt des Isoliergases und/oder des Isolierfeststoffes erfasst wird, wobei ein Messsignal erzeugt und ausgewertet wird.

7. Verfahren nach Anspruch 6,
wobei zum Erfassen des Reaktionsproduktes eine Gasprobe aus einem Gasraum (9) des Isolierkörpers (2) entnommen und dem Sensor (10) zugeführt wird.

8. Verfahren nach Anspruch 7,
wobei die Gasprobe in Zeitabständen von mindestens 24h wiederholt entnommen wird.

9. Verfahren nach einem der Ansprüche 6 bis 8,
wobei das Auswerten ein Abgleichen mit vorbestimmten Referenzdaten umfasst.

10. Verfahren nach einem der Ansprüche 6 bis 9,
wobei das Auswerten ein Erkennen einer Teilentladung in der Hochspannungsdurchführung (1) umfasst.
